# EUROPEAN PATENT APPLICATION

(11) **EP 4 261 688 A1**
(43) Date of publication of application: **18.10.2023**
(21) Application number: 21919895.9
(22) Date of filing: 09.12.2021
(51) Int. Cl.: G06F 11/22, G06F 9/4401

(54) **ELECTRONIC DEVICE FOR PERFORMING TEST FOR DETECTING FAULT OF ELECTRONIC DEVICE, AND METHOD BY WHICH ELECTRONIC DEVICE PERFORMS TEST FOR DETECTING FAULT OF ELECTRONIC DEVICE**

(30) Priority: 13.01.2021 KR 20210004622
(71) Applicant: Samsung Electronics Co., Ltd., Suwon-si, Gyeonggi-do 16677 (KR)
(72) Inventor: CHOI, Dongmin, Suwon-si Gyeonggi-do 16677 (KR); KWON, Sehong, Suwon-si Gyeonggi-do 16677 (KR); OH, Dongho, Suwon-si Gyeonggi-do 16677 (KR); LEE, Jiseong, Suwon-si Gyeonggi-do 16677 (KR); CHO, Junghoon, Suwon-si Gyeonggi-do 16677 (KR)
(74) Representative: Nederlandsch Octrooibureau
(86) International application number: PCT/KR2021/018663
(87) International publication number: WO 2022/154271

(57) **Abstract**

According to various embodiments, an electronic device comprises: an application processor including an AP internal memory; a power supply apparatus; a volatile memory; and a non-volatile memory, and may be configured to: enter an emergency mode by using the application processor, load a first boot service on the AP internal memory; and test at least one of the power supply apparatus, the volatile memory, or the non-volatile memory, by using the first boot service. Various other embodiments are possible.

## Description

### [Technical Field]

Various embodiments relates to an electronic device performing a test for detecting a fault in the electronic device and a method for performing a test for detecting a fault in an electronic device by the electronic device.

### [Background Art]

When a fault occurs in one or more of various components included in an electronic device, the tester may boot up the electronic device and conduct a test to detect the faulty component. The tester may conduct the electronic device using a diagnosis tool present for each type of electronic device. The test may be a test for a function that may be provided in an environment in which the electronic device downloads the user binary.

### [Detailed Description of the Invention]

### [Technical Problem]

When a fault occurs in specific components of an electronic device, booting of the electronic device may be impossible. A test for a function that may be provided in an environment in which the electronic device downloaded the user binary may not be performed when the electronic device cannot be booted.

According to an embodiment, an electronic device may load a boot service to a memory inside an application processor using an emergency mode provided by the application processor and test components included in the electronic device using the boot service loaded on the memory in the application processor.

### [Technical Solution]

According to an embodiment, an electronic device may comprise an application processor including an AP internal memory, a power supply device, a volatile memory, and a non-volatile memory. The electronic device may be configured to enter an emergency mode using the application processor, load a first boot service to the AP internal memory, and test at least one of the power supply device, the volatile memory, or the non-volatile memory using the first boot service.

According to an embodiment, a method performed in an electronic device may comprise entering an emergency mode using an application processor of the electronic device, loading a first boot service to an AP internal memory included in the application processor, and testing at least one of a power supply device, a volatile memory, or a non-volatile memory of the electronic device, using the first boot service.

### [Advantageous Effects]

According to an embodiment, there are provided an electronic device performing a test for detecting a fault in the electronic device and a method for performing a test for detecting a fault in an electronic device by the electronic device. According to an embodiment, an electronic device may load a boot service to a memory inside an application processor using an emergency mode provided by the application processor and test components included in the electronic device using the boot service loaded on the memory in the application processor. Since the emergency mode provided by the application processor is available even in a context where the booting of the electronic device is impossible, the electronic device according to an embodiment may perform a test for detecting a fault in the embedded components.

### [Brief Description of the Drawings]

FIG. 1 is a view illustrating an electronic device in a network environment according to various embodiments;
FIG. 2 is a block diagram illustrating an electronic device according to various embodiments;
FIG. 3 is a flowchart illustrating operations performed in an electronic device according to various embodiments;
FIG. 4 is a flowchart illustrating operations performed in an electronic device according to various embodiments;
FIG. 5 is a flowchart illustrating operations performed in an electronic device according to various embodiments;
FIG. 6 is a flowchart illustrating operations performed in an electronic device according to various embodiments;
FIG. 7 illustrates operations performed in an electronic device and an external electronic device according to various embodiments; and
FIG. 8 illustrates operations performed in an electronic device and an external electronic device according to various embodiments.

### [Mode for Carrying out the Invention]

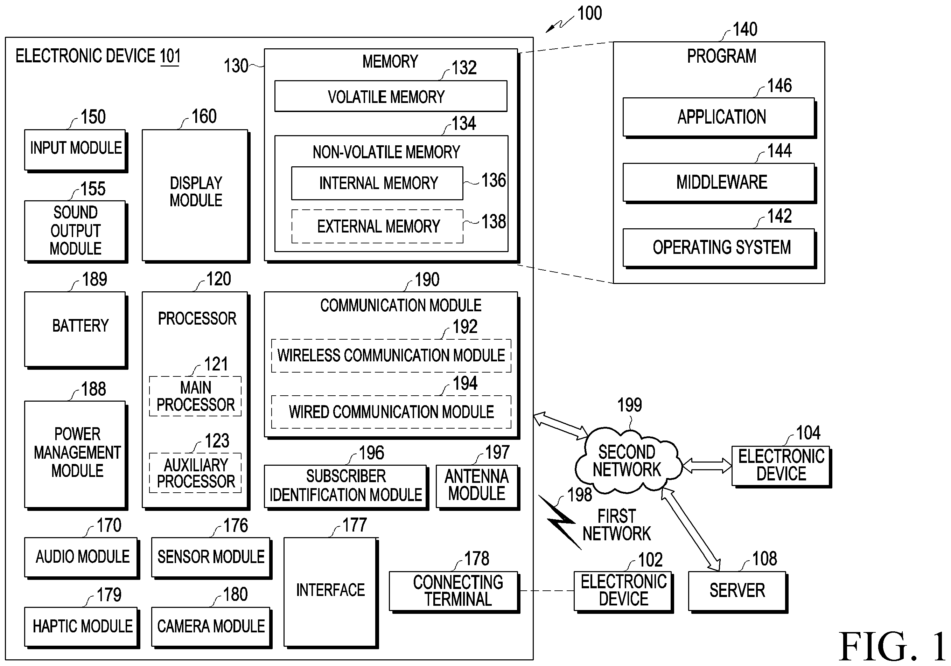

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network).According to an embodiment, the electronic device 101 may communicate with the electronic device 104 via the server 108.According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197.In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software(e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134.According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application).According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101.The various data may include, for example, software (e.g., the program 140) and input data or output data for a command related thereto.The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101.The input module 150 may include, for example, a microphone, a mouse, a keyboard, keys (e.g., buttons), or a digital pen (e.g., a stylus pen).

The sound output module 155 may output sound signals to the outside of the electronic device 101.The sound output module 155 may include, for example, a speaker or a receiver.The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101.The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102)directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state.According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102).According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101.According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module).A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)).These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductive body or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmittedor received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101, According to an embodiment, all or some of operations to be executed at the electronic device 101 may be executed at one or more of the external electronic devices 102, 104, or 108.For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

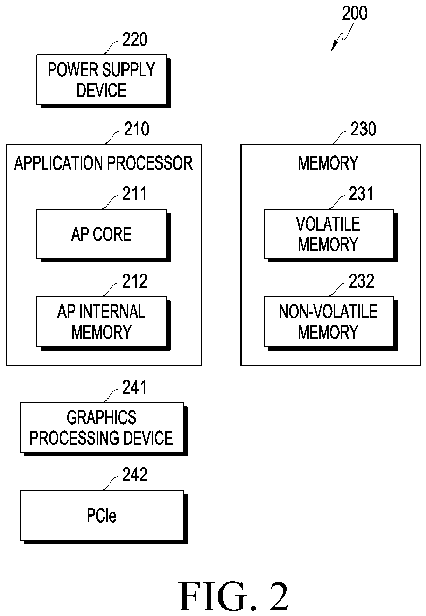

FIG. 2 is a block diagram illustrating an electronic device according to various embodiments. Referring to FIG. 2, according to various embodiments, an electronic device 200 may include an application processor 210, a power supply device 220, a memory 230, a graphics processing device 241, and a peripheral component interconnect express (PCIe) 242.

The electronic device 200 may be implemented in substantially the same or similar manner to the electronic device 101 described above in connection with FIG. 1. For example, the electronic device 200 may be implemented as various devices, such as a terminal, smartphone, or wearable electronic device capable of performing a communication function.

According to various embodiments, the application processor 210 may allow the electronic device 200 to enter an emergency mode based on a specific trigger. The emergency mode may be a mode for the application processor 210 to drive a code including a function for downloading the user binary. When the electronic device 200 enters the emergency mode, only minimum components for downloading the user binary among the components of the electronic device 200 may be driven. For example, when the electronic device 200 enters the emergency mode, the application processor 210, the power supply device 220, the memory 230, the graphics processing device 241, and the peripheral component interconnect express (PCIe) 242 among the components of the electronic device 200 may be driven.

According to various embodiments, the trigger for the electronic device 200 to enter the emergency mode may occur inside the electronic device 200. For example, the electronic device 200 may include an input interface, such as a physical key button, and making a predetermined input using the input interface may be the trigger.

According to various embodiments, the trigger for the electronic device 200 to enter the emergency mode may occur outside the electronic device 200. For example, the electronic device 200 may be connected to an external electronic device, and making a predetermined input for the electronic device 200 to enter the emergency mode through the external electronic device may be trigger.

According to various embodiments, the application processor 210 may include an AP core 211 and an AP internal memory 212.

According to various embodiments, the power supply device 220 may manage the power supplied to each component of the electronic device 200. According to various embodiments, the power supply device 220 may include a power management integrated circuit (PMIC).

According to various embodiments, the memory 230 may include a volatile memory 231 and a non-volatile memory 232. The memory 230 may be implemented in substantially the same or similar manner to the memory 130 described above in connection with FIG. 1. According to various embodiments, the volatile memory 231 may include a dynamic random access memory (DRAM). According to various embodiments, the volatile memory 231 may include a double data rate (DDR) memory. According to various embodiments, the non-volatile memory 232 may include a universal flash storage (UFS) memory.

FIG. 2 only illustrates components tested according to various embodiments among the components of the electronic device. According to various embodiments, the electronic device 200 may further include other components not shown in FIG. 2. Further, although not shown in FIG. 2, according to various embodiments, the electronic device 200 may further include other peripheral devices than the graphics processing device 241 and the PCIe 242.

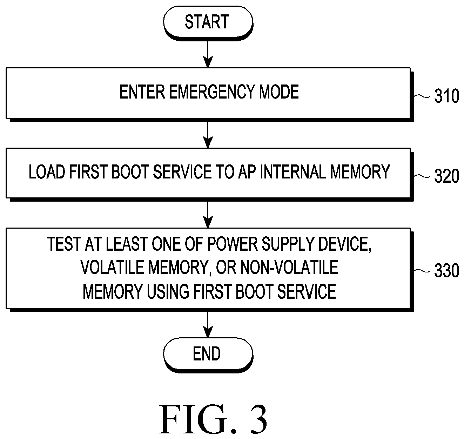

FIG. 3 is a flowchart illustrating operations performed in an electronic device according to various embodiments. In operation 310, the electronic device (e.g., the electronic device 200) may enter the emergency mode using the application processor 210. The emergency mode may be a mode for the application processor 210 to drive a code including a function for downloading the user binary. When the electronic device 200 enters the emergency mode, only minimum components for downloading the user binary among the components of the electronic device 200 may be driven. For example, when the electronic device 200 enters the emergency mode, the application processor 210, the power supply device 220, the memory 230, the graphics processing device 241, and the peripheral component interconnect express (PCIe) 242 among the components of the electronic device 200 may be driven.

As described below, according to various embodiments, the trigger for the electronic device 200 to enter the emergency mode may occur inside the electronic device 200 or outside the electronic device 200.

In operation 320, the electronic device 200 may load a first boot service to the AP internal memory 212 (e.g., internal RAM). According to various embodiments, the first boot service may be a prerequisite necessary for performing a second boot service to be described below. The first boot service may be used to test at least one of the power supply device 220, the volatile memory 231, or the non-volatile memory 232, which are components for downloading the user binary.

As is described below, according to various embodiments, the first boot service may be loaded from a boot partition of the electronic device 200 to the AP internal memory 212. Alternatively, according to various embodiments, the first boot service may be loaded to the AP internal memory 212 from an external electronic device connected to the electronic device 200.

In operation 330, the electronic device 200 may test at least one of the power supply device 220, the volatile memory 231, or the non-volatile memory 232 using the first boot service loaded to the AP internal memory 212.

According to various embodiments, the electronic device 200 may test the power supply device 220 using the PMIC internal memory and register included in the power supply device 220 using the first boot service loaded to the AP internal memory 212.

According to various embodiments, the electronic device 200 may identify whether a proper operation margin is secured for each of several DDR frequencies when the volatile memory 231 performs DDR training, as part of testing the volatile memory 231. According to various embodiments, after the DDR training of the volatile memory 231 is completed, the electronic device 200 may set a DDR entire area for each of the several DDR frequencies and verify operations of channels and cells of the volatile memory 231, as part of testing the volatile memory 231. According to various embodiments, the electronic device 200 may perform a read/write test and a refresh test on the volatile memory 231, as part of testing the volatile memory 231.

According to various embodiments, the electronic device 200 may perform a UFS link startup, UFS scan, UFS read/write, and UFS clock gating function provided by a UFS included in the volatile memory 231, as part of testing the non-volatile memory 232.

Although not shown in FIG. 3, according to various embodiments, after performing operation 330, upon identifying that at least one of the power supply device 220, the volatile memory 231, or the non-volatile memory 232 is faulty, the electronic device 200 may inform the external electronic device of the fault. According to various embodiments, the electronic device 200 may be connected to the external electronic device through a communication interface (e.g., UART communication, the interface 177 of FIG. 1) and inform the external electronic device that at least one of the power supply device 220, the volatile memory 231, or the non-volatile memory 232 is faulty through the communication interface (e.g., UART communication). Although UART communication is mentioned as an example of the communication interface in the disclosure, the disclosure is not limited thereto.

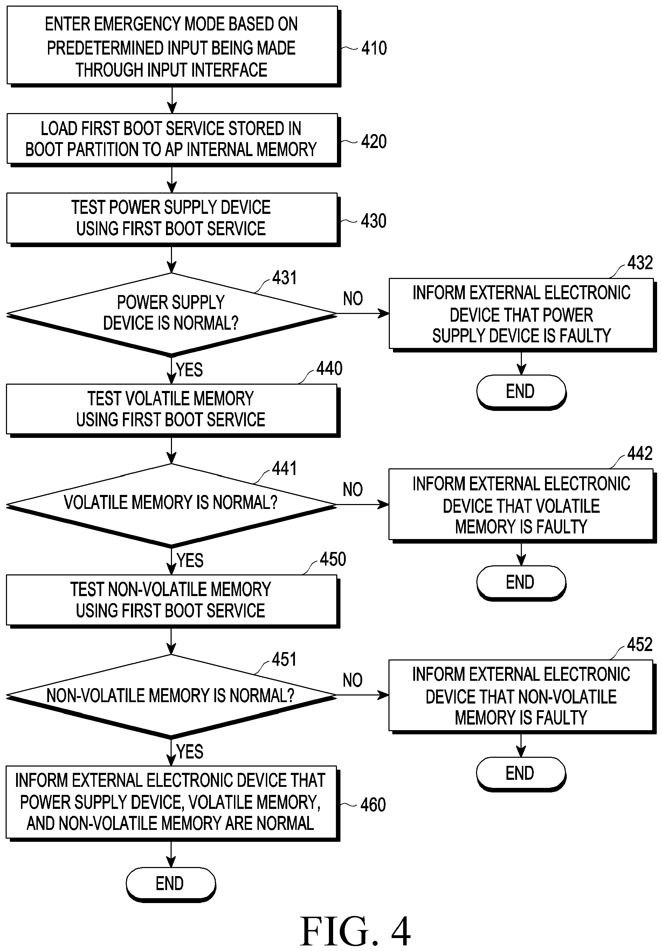

FIG. 4 is a flowchart illustrating operations performed in an electronic device according to various embodiments. In operation 410, the electronic device (e.g., the electronic device 200) may enter the emergency mode using the application processor 210 based on a predetermined input through an input interface. According to various embodiments, when the input interface is a physical key, the electronic device 200 may enter the emergency mode in response to a key input of a specific combination of physical keys. The emergency mode is the same as that described above in connection with operation 310 of FIG. 3.

In operation 420, the electronic device 200 may load the first boot service stored in the boot partition of the electronic device 200 to the AP internal memory 212. The first boot service is the same as that described above in connection with operation 320.

In operation 430, the electronic device 200 may test the power supply device 220 using the first boot service loaded to the AP internal memory 212. According to various embodiments, the electronic device 200 may test the power supply device 220 using the PMIC internal memory and register included in the power supply device 220.

In operation 431, the electronic device 200 may identify whether the power supply device 220 is normal as a result of operation 430.

Upon identifying that the power supply device 220 is abnormal in operation 431, the electronic device 200 may inform the external electronic device that the power supply device 220 is faulty in operation 432. According to various embodiments, the electronic device 200 may inform the external electronic device that the power supply device 220 is faulty through UART communication. According to various embodiments, the electronic device 200 may identify the external electronic device which part of the test the power supply device 220 had a fault in.

Upon identifying that the power supply device 220 is normal in operation 431, the electronic device 200 may test the volatile memory 231 using the first boot service loaded to the AP internal memory 212 in operation 440. According to various embodiments, the electronic device 200 may identify whether a proper operation margin is secured for each of several DDR frequencies when the volatile memory 231 performs DDR training, as part of testing the volatile memory 231. According to various embodiments, after the DDR training of the volatile memory 231 is completed, the electronic device 200 may set a DDR entire area for each of the several DDR frequencies, and verify operations of channels and cells of the volatile memory 231, as part of testing the volatile memory 231. According to various embodiments, the electronic device 200 may perform a read/write test and a refresh test on the volatile memory 231, as part of testing the volatile memory 231.

In operation 441, the electronic device 200 may identify whether the volatile memory 231 is normal as a result of operation 440.

Upon identifying that the volatile memory 231 is abnormal in operation 441, the electronic device 200 may inform the external electronic device that the volatile memory 231 is faulty in operation 442. According to various embodiments, the electronic device 200 may inform the external electronic device that the volatile memory 231 is faulty through UART communication. According to various embodiments, the electronic device 200 may identify the external electronic device which part of the test the volatile memory 231 had a fault in.

Upon identifying that the volatile memory 231 is normal in operation 441, the electronic device 200 may test the non-volatile memory 232 using the first boot service loaded to the AP internal memory 212 in operation 450. According to various embodiments, the electronic device 200 may perform a UFS link startup, UFS scan, UFS read/write, and UFS clock gating function provided by a UFS included in the volatile memory 231, as part of testing the non-volatile memory 232.

In operation 451, the electronic device 200 may identify whether the non-volatile memory 232 is normal as a result of operation 450.

Upon identifying that the non-volatile memory 232 is abnormal in operation 451, the electronic device 200 may inform the external electronic device that the non-volatile memory 232 is faulty in operation 452. According to various embodiments, the electronic device 200 may inform the external electronic device that the non-volatile memory 232 is faulty through UART communication. According to various embodiments, the electronic device 200 may identify the external electronic device which part of the test the non-volatile memory 232 had a fault in.

Upon identifying that the non-volatile memory 232 is normal in operation 451, the electronic device 200 may inform the external electronic device that the power supply device 220, the volatile memory 231, and the non-volatile memory 232 are normal in operation 460. According to various embodiments, operation 460 may be omitted.

As is described below, operations 430 to 432, operations 440 to 442, and operations 450 to 452 of testing the power supply device 220, the volatile memory 231, and the non-volatile memory 232 and, if any one is faulty, informing the external electronic device may be referred to as a first test.

According to various embodiments, the order of operations 440 to 452 may be changed. For example, operation 450 of identifying the status of the non-volatile memory may be performed before operation 440 of identifying the status of the volatile memory.

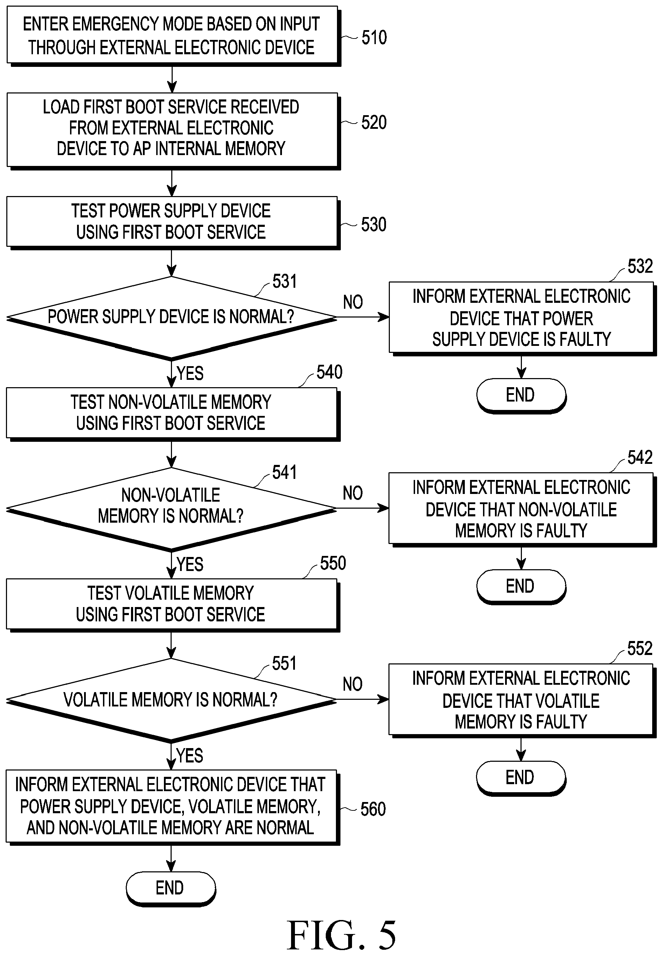

FIG. 5 is a flowchart illustrating operations performed in an electronic device according to various embodiments. According to various embodiments, the operations of FIG. 5 may be performed when access to the boot partition of the electronic device 200 is impossible or when a predetermined input for accessing the emergency mode using the input interface of the electronic device 200 cannot be made.

In operation 510, the electronic device (e.g., the electronic device 200) may enter the emergency mode based on making a predetermined input through an external electronic device connected to the electronic device 200. The emergency mode is the same as that described above in connection with operation 310 of FIG. 3.

In operation 520, the electronic device 200 may load the first boot service received from the external electronic device to the AP internal memory 212. The first boot service is the same as that described above in connection with operation 320.

In operation 530, the electronic device 200 may test the power supply device 220 using the first boot service loaded to the AP internal memory 212. According to various embodiments, the electronic device 200 may test the power supply device 220 using the PMIC internal memory and register included in the power supply device 220.

In operation 531, the electronic device 200 may identify whether the power supply device 220 is normal as a result of operation 530.

Upon identifying that the power supply device 220 is abnormal in operation 531, the electronic device 200 may inform the external electronic device that the power supply device 220 is faulty in operation 532. According to various embodiments, the electronic device 200 may inform the external electronic device that the power supply device 220 is faulty through UART communication. According to various embodiments, the electronic device 200 may identify the external electronic device which part of the test the power supply device 220 had a fault in.

Upon identifying that the power supply device 220 is normal in operation 531, the electronic device 200 may test the non-volatile memory 232 using the first boot service loaded to the AP internal memory 212 in operation 540. According to various embodiments, the electronic device 200 may perform a UFS link startup, LTFS scan, UFS read/write, and LTFS clock gating function provided by a UFS included in the volatile memory 231, as part of testing the non-volatile memory 232.

In operation 541, the electronic device 200 may identify whether the non-volatile memory 232 is normal as a result of operation 540.

Upon identifying that the non-volatile memory 232 is abnormal in operation 541, the electronic device 200 may inform the external electronic device that the non-volatile memory 232 is faulty in operation 542. According to various embodiments, the electronic device 200 may inform the external electronic device that the non-volatile memory 232 is faulty through UART communication. According to various embodiments, the electronic device 200 may identify the external electronic device which part of the test the non-volatile memory 232 had a fault in.

Upon identifying that the non-volatile memory 232 is normal in operation 541, the electronic device 200 may test the volatile memory 231 using the first boot service loaded to the AP internal memory 212 in operation 550. According to various embodiments, the electronic device 200 may identify whether a proper operation margin is secured for each of several DDR frequencies when the volatile memory 231 performs DDR training, as part of testing the volatile memory 231. According to various embodiments, the electronic device 200 may set a DDR entire area for each of the several DDR frequencies for the volatile memory 231 completes the DDR training, and verify operations of channels and cells of the volatile memory 231, as part of testing the volatile memory 231. According to various embodiments, the electronic device 200 may perform a read/write test and a refresh test on the volatile memory 231, as part of testing the volatile memory 231.

In operation 551, the electronic device 200 may identify whether the volatile memory 231 is normal as a result of operation 550.

Upon identifying that the volatile memory 231 is abnormal in operation 551, the electronic device 200 may inform the external electronic device that the volatile memory 231 is faulty in operation 552. According to various embodiments, the electronic device 200 may inform the external electronic device that the volatile memory 231 is faulty through UART communication. According to various embodiments, the electronic device 200 may identify the external electronic device which part of the test the volatile memory 231 had a fault in.

Upon identifying that the volatile memory 231 is normal in operation 551, the electronic device 200 may inform the external electronic device that the power supply device 220, the volatile memory 231, and the non-volatile memory 232 are normal in operation 560. According to various embodiments, operation 560 may be omitted.

According to various embodiments, the order of operations 540 to 552 may be changed. For example, operation 550 of identifying the status of the volatile memory may be performed before operation 540 of identifying the status of the non-volatile memory.

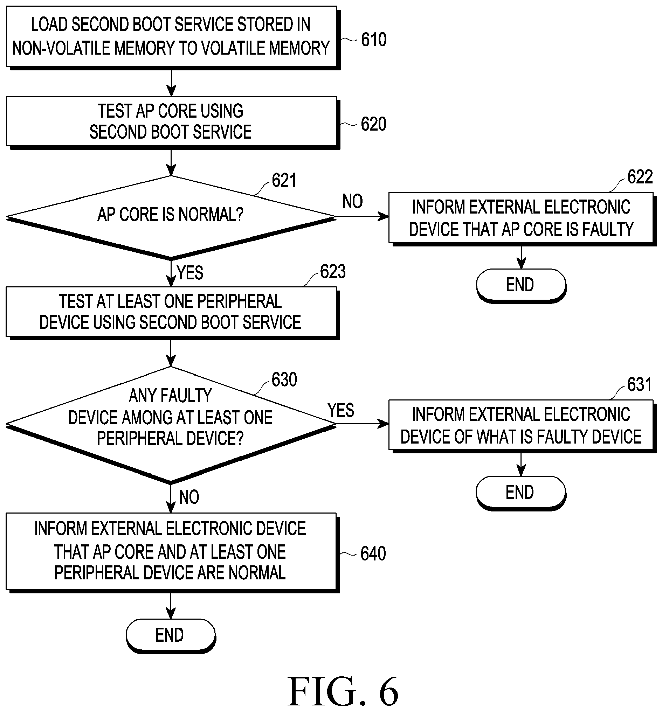

FIG. 6 is a flowchart illustrating operations performed in an electronic device according to various embodiments. According to various embodiments, FIG. 6 may be performed by the electronic device 200 in which the power supply device 220, the volatile memory 231, and the non-volatile memory 232 are identified as normal through the operations shown in FIG. 4 or the operations shown in FIG. 5.

In operation 610, the electronic device (e.g., the electronic device 200) may load a second boot service stored in the non-volatile memory 232 to the volatile memory 231. According to various embodiments, the second boot service may be stored in a boot area of the non-volatile memory 232. According to various embodiments, the second boot service may be received from an external electronic device and stored in the non-volatile memory 232.

In operation 620, the electronic device (e.g., the electronic device 200) may test the AP core 211 using the second boot service loaded to the volatile memory 231. According to various embodiments, the electronic device 200 may perform an encryption algorithm and/or a compression algorithm, e.g., zip/unzip, using ARM CE commands on each of various AP frequencies, as at least part of testing the AP core 211. According to various embodiments, the electronic device 200 may check whether the cache is used and perform a policy change test to identify whether the cache is faulty, as at least part of testing the AP core 211.

In operation 621, the electronic device 200 may identify whether the AP core 211 is normal as a result of operation 620.

Upon identifying that the AP core 211 is abnormal in operation 621, the electronic device 200 may inform the external electronic device that the AP core 211 is faulty in operation 622. According to various embodiments, the electronic device 200 may inform the external electronic device that the AP core 211 is faulty through UART communication. According to various embodiments, the electronic device 200 may identify the external electronic device which part of the test the AP core 211 had a fault in.

Upon identifying that the AP core 211 is normal in operation 621, the electronic device 200 may test at least one peripheral device of the electronic device 200 using the second boot service loaded to the volatile memory 231 in operation 623.

According to various embodiments, the electronic device 200 may test the graphics processing device 241 in operation 623. According to various embodiments, the electronic device 200 may create a specific image, render the created image using the graphics processing device 241, and compare the images before and after rendering, as at least part of testing the graphics processing device 241.

According to various embodiments, the electronic device 200 may test the PCIe 242 in operation 623. According to various embodiments, the electronic device 200 may perform a link width/speed change test and/or a pipe loopback test, as at least part of testing the PCIe 242.

In operation 630, the electronic device 200 may identify whether there is a faulty device among the one or more peripheral devices tested in operation 623.

Upon identifying there is a faulty peripheral device in operation 630, the electronic device 200 may inform the external electronic device what the faulty device is in operation 631. According to various embodiments, the electronic device 200 may inform the external electronic device what the faulty device is through UART communication. According to various embodiments, the electronic device 200 may inform the external electronic device what part in the test the faulty device had the fault.

Upon identifying that there is no faulty peripheral device in operation 630, the electronic device 200 may inform the external electronic device that the AP core 211 and the one or more peripheral devices tested in operation 623 are normal in operation 640. According to various embodiments, the electronic device 200 may inform the external electronic device what the faulty device is through UART communication. According to various embodiments, operation 640 may be omitted.

As is described below, operations 620 to 623, operation 630, and operation 631 of testing the AP core 211 and the peripheral devices and, if any one is faulty, informing the external electronic device may be referred to as a second test.

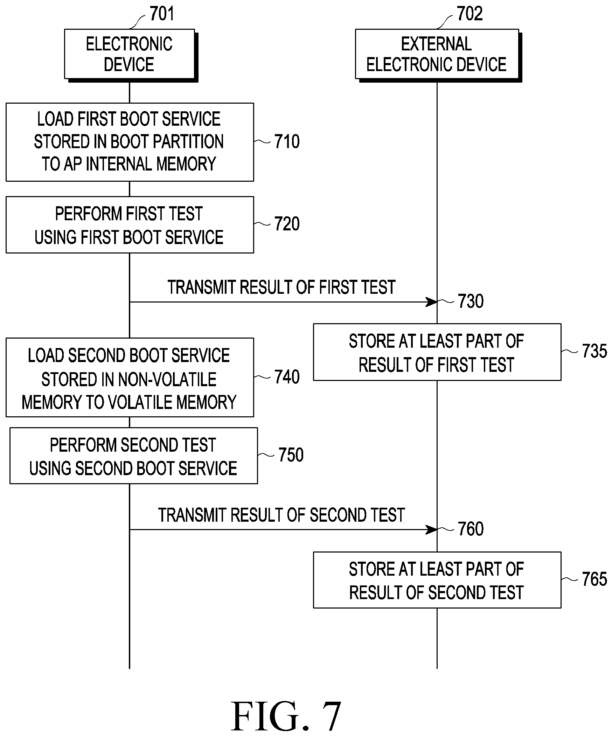

FIG. 7 illustrates operations performed in an electronic device and an external electronic device according to various embodiments. In operation 710, an electronic device 701 (e.g., the electronic device 200) may load the first boot service stored in the boot partition of the electronic device 200 to the AP internal memory 212. The first boot service is the same as that described above in connection with operation 320.

In operation 720, the electronic device 701 may perform the first test using the first boot service loaded to the AP internal memory 212. Here, the first test may mean a test on the power supply device 220, the volatile memory 231, and the non-volatile memory 232. Details of the test on the power supply device 220 are the same as those described in connection with operation 430 of FIG. 4. Details of the test on the volatile memory 231 are the same as those described in connection with operation 440 of FIG. 4. Details of the test on the non-volatile memory 232 are the same as those described in connection with operation 450 of FIG. 4.

In operation 730, the electronic device 701 may transmit a result of the first test to an external electronic device 702. According to various embodiments, the electronic device 701 may transmit the result of the first test to the external electronic device 702 through UART communication. As at least part of operation 730, operations 432, 442, 452, and 460 of FIG. 4 may be performed.

In operation 735, the external electronic device 702 may store at least a portion of the result of the first test. According to various embodiments, the external electronic device 702 may store only information regarding the faulty component, without storing information regarding the normal components as the result of the first test. According to various embodiments, the external electronic device 702 may store the entire result of the first test. According to various embodiments, the external electronic device 702 may store at least a portion of the result of the first test in association with the time of reception of the result of the first test and/or information regarding the electronic device 701.

In operation 740, the electronic device 701 may load the second boot service stored in the boot area of the non-volatile memory (e.g., the non-volatile memory 232) to the volatile memory 231.

In operation 750, the electronic device 701 may perform the second test using the second boot service loaded to the volatile memory 231. Here, the second test may mean a test on the AP core 211 and peripheral devices, such as the graphics processing device 241 and/or the PCIe 242. Details of the test on the AP core 211 are the same as those described in connection with operation 620 of FIG. 6. Details of the test on the graphics processing device 241 and details of the test on the PCIe 242 are the same as those described in connection with operation 623 of FIG. 6.

In operation 760, the electronic device 701 may transmit a result of the second test to an external electronic device 702. According to various embodiments, the electronic device 701 may transmit the result of the second test to the external electronic device 702 through UART communication. As at least part of operation 760, operations 622, 631, and 640 of FIG. 6 may be performed.

In operation 765, the external electronic device 702 may store at least a portion of the result of the second test. According to various embodiments, the external electronic device 702 may store only information regarding the faulty component, without storing information regarding the normal components as the result of the second test. According to various embodiments, the external electronic device 702 may store the entire result of the second test. According to various embodiments, the external electronic device 702 may store at least a portion of the result of the second test in association with the time of reception of the result of the second test and/or information regarding the electronic device 701.

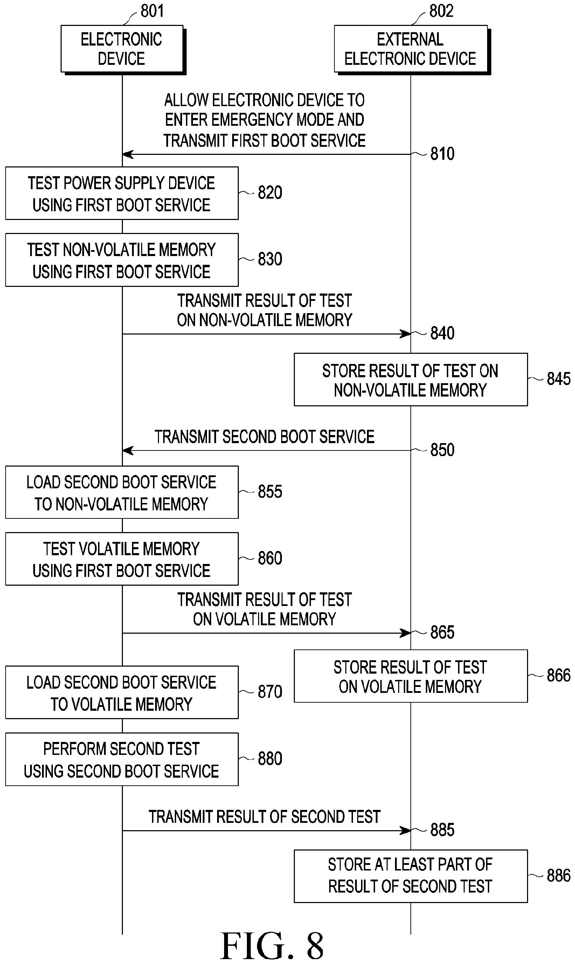

FIG. 8 illustrates operations performed in an electronic device and an external electronic device according to various embodiments. In operation 810, an external electronic device 802 may allow an electronic device 801 (e.g., the electronic device 200) to enter the emergency mode and transmit the first boot service to the electronic device 801. According to various embodiments, in a state in which the external electronic device 802 is connected with the electronic device 801, the external electronic device 802 may receive a predetermined input for allowing the electronic device 801 to enter the emergency mode from the user and, in response to the predetermined input, allow the electronic device 801 to enter the emergency mode. The first boot service is the same as that described above in connection with operation 320. The first boot service transmitted to the electronic device 801 may be loaded to the AP internal memory 212 of the electronic device 801.

In operation 820, the electronic device 801 may test the power supply device 220 using the first boot service loaded to the AP internal memory 212. Details of the test on the power supply device 220 are the same as those described in connection with operation 530 of FIG. 5.

Upon identifying that the power supply device 220 is normal in operation 820, the electronic device 801 may test the non-volatile memory 232 using the first boot service loaded to the AP internal memory 212 in operation 830. Details of the test on the non-volatile memory 232 are the same as those described in connection with operation 540 of FIG. 5.

In operation 840, the electronic device 801 may transmit the result of the test on the non-volatile memory 232 to the external electronic device 802. According to various embodiments, the electronic device 801 may transmit the result of the test on the power supply device 220, along with the result of the test on the non-volatile memory 232, to the external electronic device 802 in operation 840.

In operation 845, the external electronic device 802 may store at least a portion of the result of the test on the non-volatile memory 232. In operation 840, upon receiving the result of the test on the power supply device 220 along with the result of the test on the non-volatile memory 232, the external electronic device 802 may store at least a portion of the result of the test on the power supply device 220 and the result of the test on the non-volatile memory 232. According to various embodiments, the external electronic device 802 may store only information regarding the faulty component, without storing information regarding the normal components as the result of the test received in operation 840. According to various embodiments, the external electronic device 802 may store the entire result of the test received in operation 840. According to various embodiments, the external electronic device 802 may store at least a portion of the result of the test received in operation 840 in association with the time of reception of the result of the test and/or information regarding the electronic device 801.

When the non-volatile memory 232 is normal, the external electronic device 802 may transmit the second boot service to the electronic device 801 in operation 850. The electronic device 801 may load the second boot service to the non-volatile memory 232 in operation 855.

In operation 860, the electronic device 801 may test the volatile memory 231 using the first boot service loaded to the AP internal memory 212. Details of the test on the volatile memory 231 are the same as those described in connection with operation 550 of FIG. 5.

In operation 865, the electronic device 801 may transmit the result of the test on the volatile memory 231 to the external electronic device 802.

In operation 866, the external electronic device 802 may store at least a portion of the result of the test on the volatile memory 231. According to various embodiments, when the volatile memory 231 is normal, the external electronic device 802 may not store the result of the test and, only when the volatile memory 231 has a fault, store the result of the test. According to various embodiments, the external electronic device 802 may equally store the result of the test received in operation 865. According to various embodiments, the external electronic device 802 may store at least a portion of the result of the test received in operation 865 in association with the time of reception of the result of the test and/or information regarding the electronic device 801.

When the volatile memory 231 is normal, the electronic device 801 may load the second boot service, loaded to the non-volatile memory 232, to the volatile memory 231 in operation 870.

In operation 880, the electronic device 801 may perform the second test using the second boot service loaded to the volatile memory 231. Here, the second test may mean a test on the AP core 211 and peripheral devices, such as the graphics processing device 241 and/or the PCIe 242. Details of the test on the AP core 211 are the same as those described in connection with operation 620 of FIG. 6. Details of the test on the graphics processing device 241 and details of the test on the PCIe 242 are the same as those described in connection with operation 623 of FIG. 6.

In operation 885, the electronic device 801 may transmit a result of the second test to an external electronic device 802. According to various embodiments, the electronic device 801 may transmit the result of the second test to the external electronic device 802 through UART communication. As at least part of operation 885, operations 622, 631, and 640 of FIG. 6 may be performed.

In operation 886, the external electronic device 802 may store at least a portion of the result of the second test. According to various embodiments, the external electronic device 802 may store only information regarding the faulty component, without storing information regarding the normal components as the result of the second test. According to various embodiments, the external electronic device 802 may store the entire result of the second test. According to various embodiments, the external electronic device 802 may store at least a portion of the result of the second test in association with the time of reception of the result of the second test and/or information regarding the electronic device 801.

According to various embodiments, an electronic device 200 may comprise an application processor 210 including an AP internal memory 212, a power supply device 220, a volatile memory 231, and a non-volatile memory 232. The electronic device 200 may be configured to enter an emergency mode using the application processor 210, load a first boot service to the AP internal memory 212, and test at least one of the power supply device 220, the volatile memory 231, or the non-volatile memory 232 using the first boot service.

According to various embodiments, the electronic device 200 may be connected to an external electronic device through UART communication and be configured to, upon identifying that at least one of the power supply device 220, the volatile memory 231, or the non-volatile memory 232 is faulty, inform the external electronic device of the fault through the UART communication.

According to various embodiments, the electronic device 200 may further comprise an input interface. The electronic device 200 may be configured to enter the emergency mode based on a predetermined input through the input interface.

According to various embodiments, the electronic device 200 may be configured to load the first boot service stored in a boot partition to the AP internal memory 212.

According to various embodiments, the electronic device 200 may be configured to, using the first boot service, test the power supply device 220 and test the volatile memory 231 when the power supply device 220 is normal, and test the non-volatile memory 232 when the volatile memory 231 is normal.

According to various embodiments, the electronic device 200 may be connected to an external electronic device. The electronic device 200 may be configured to enter the emergency mode based on an input through the external electronic device.

According to various embodiments, the electronic device 200 may be configured to load the first boot service received from the external electronic device to the AP internal memory 212.

According to various embodiments, the electronic device 200 may be configured to, using the first boot service, test the power supply device 220 and test the non-volatile memory 232 when the power supply device 220 is normal, and test the volatile memory 231 when the non-volatile memory 232 is normal.

According to various embodiments, the electronic device 200 may be configured to, when the non-volatile memory 232 is normal, load a second boot service received from the external electronic device to the volatile memory 231.

According to various embodiments, the electronic device 200 may be configured to load a second boot service stored in the non-volatile memory 232 to the volatile memory 231 in response to identifying that the volatile memory 231 and the non-volatile memory 232 are normal.

According to various embodiments, the electronic device 200 may further comprise at least one peripheral device. The electronic device 200 may be configured to, using the second boot service loaded to the volatile memory 231, test an AP core 211 of the application processor 210 and, when the AP core 211 is normal, test the at least one peripheral device.

According to various embodiments, the at least one peripheral device may include at least one of a graphics processing device 241 or a peripheral component interconnect express (PCIe) 242.

According to various embodiments, the electronic device 200 may be connected to an external electronic device through UART communication and be configured to, upon identifying that at least one of the AP core 211 and the at least one peripheral device is faulty, inform the external electronic device of the fault through the UART communication.

According to various embodiments, a method performed in an electronic device 200 may comprise entering an emergency mode using an application processor 210 of the electronic device 200, loading a first boot service to an AP internal memory 212 included in the application processor 210, and testing at least one of a power supply device 220, a volatile memory 231, or a non-volatile memory 232 of the electronic device 200, using the first boot service.

According to various embodiments, the method may further comprise, upon identifying that at least one of the power supply device 220, the volatile memory 231, or the non-volatile memory 232 is faulty, informing an external electronic device of the fault through UART communication.

According to various embodiments, testing at least one of the power supply device 220, the volatile memory 231, or the non-volatile memory 232 of the electronic device 200 using the first boot service may include testing the power supply device 220, testing the volatile memory 231 when the power supply device 220 is normal, and testing the non-volatile memory 232 when the volatile memory 231 is normal.

According to various embodiments, testing at least one of the power supply device 220, the volatile memory 231, or the non-volatile memory 232 of the electronic device 200 using the first boot service may include testing the power supply device 220, testing the non-volatile memory 232 when the power supply device 220 is normal, and testing the volatile memory 231 when the non-volatile memory 232 is normal.

According to various embodiments, the method may further comprise loading a second boot service stored in the non-volatile memory 232 to the volatile memory 231 in response to identifying that the volatile memory 231 and the non-volatile memory 232 are normal.

According to various embodiments, the method may further comprise, using the second boot service loaded to the volatile memory 231, testing an AP core 211 of the application processor 210 and testing at least one peripheral device of the electronic device 200 when the AP core 211 is normal.

According to various embodiments, the at least one peripheral device may include at least one of a graphics processing device 241 or a peripheral component interconnect express (PCIe) 242.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order).It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101).For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
an application processor including an AP internal memory;
a power supply device;
a volatile memory; and
a non-volatile memory,
wherein the electronic device is configured to:
enter an emergency mode using the application processor,
load a first boot service to the AP internal memory, and
test at least one of the power supply device, the volatile memory, or the non-volatile memory using the first boot service.

2. The electronic device of claim 1, wherein the electronic device is connected to an external electronic device through UART communication and configured to, upon identifying that at least one of the power supply device, the volatile memory, or the non-volatile memory is faulty, inform the external electronic device of the fault through the UART communication.

3. The electronic device of claim 1, further comprising an input interface, wherein the electronic device is configured to enter the emergency mode based on a predetermined input through the input interface.

4. The electronic device of claim 1, wherein the electronic device is configured to load the first boot service stored in a boot partition to the AP internal memory.

5. The electronic device of claim 1, wherein the electronic device is configured to, using the first boot service, test the power supply device, test the volatile memory when the power supply device is normal, and test the non-volatile memory when the volatile memory is normal.

6. The electronic device of claim 1, wherein the electronic device is connected to an external electronic device, and wherein the electronic device is configured to enter the emergency mode based on an input through the external electronic device.

7. The electronic device of claim 6, wherein the electronic device is configured to load the first boot service received from the external electronic device to the AP internal memory.

8. The electronic device of claim 6, wherein the electronic device is configured to, using the first boot service, test the power supply device, test the non-volatile memory when the power supply device is normal, and test the volatile memory when the non-volatile memory is normal.

9. The electronic device of claim 8, wherein the electronic device is configured to, when the non-volatile memory is normal, load a second boot service received from the external electronic device to the volatile memory.

10. The electronic device of claim 1, wherein the electronic device is configured to load a second boot service stored in the non-volatile memory to the volatile memory in response to identifying that the volatile memory and the non-volatile memory are normal.

11. The electronic device of claim 10, further comprising at least one peripheral device, wherein the electronic device is configured to, using the second boot service loaded to the volatile memory, test an AP core of the application processor and, when the AP core is normal, test the at least one peripheral device.

12. The electronic device of claim 11, wherein the at least one peripheral device includes at least one of a graphics processing device or a peripheral component interconnect express (PCIe).

13. The electronic device of claim 10, wherein the electronic device is connected to an external electronic device through UART communication and is configured to, upon identifying that at least one of the AP core and the at least one peripheral device is faulty, inform the external electronic device of the fault through the UART communication.

14. A method performed in an electronic device, the method comprising:
entering an emergency mode using an application processor of the electronic device;
loading a first boot service to an AP internal memory included in the application processor; and
testing at least one of a power supply device, a volatile memory, or a non-volatile memory of the electronic device, using the first boot service.

15. The method of claim 14, further comprising, upon identifying that at least one of the power supply device, the volatile memory, or the non-volatile memory is faulty, informing an external electronic device of the fault through UART communication.
